(19) **Europäisches Patentamt**

**European Patent Office**

**Office européen des brevets**

(11) **EP 0 793 153 B1**

(12) **FASCICULE DE BREVET EUROPEEN**

(45) Date de publication et mention
de la délivrance du brevet:
**13.09.2000 Bulletin 2000/37**

(51) Int Cl.$^7$: **G04F 10/10**

(21) Numéro de dépôt: **97400453.3**

(22) Date de dépôt: **27.02.1997**

(54) **Dispositif de mesure précise de la durée d'un intervalle de temps et dispositif de télémétrie laser le comprenant**

Präzisionszeitintervallmessvorrichtung sowie ihn enthaltende Laser-Telemetrievorrichtung

Precision time interval measurement system and laser telemetric device comprising such system

(84) Etats contractants désignés:
**BE CH DE ES GB IT LI**

(30) Priorité: **01.03.1996 FR 9602616**

(43) Date de publication de la demande:
**03.09.1997 Bulletin 1997/36**

(73) Titulaire: **COMMISSARIAT A L'ENERGIE ATOMIQUE**
**75015 Paris (FR)**

(72) Inventeurs:
• **Besesty, Pascal**
**38410 Vaulnaveys-le-Haut (FR)**

• **Belleville, Marc**
**38120 Saint-Egreve (FR)**

(74) Mandataire: **Moutard, Pascal Jean et al**
**c/o Brevatome,**
**25, rue de Ponthieu**
**75008 Paris (FR)**

(56) Documents cités:
**EP-A- 0 165 144      EP-A- 0 632 279**
**US-A- 5 200 933**

**Description**

Domaine technique

La présente invention concerne un dispositif de mesure de la durée d'un intervalle de temps.

Le domaine de l'invention est celui de la chronométrie, de la mesure temporelle précise d'une période de temps, courte ou infiniment longue, comprise entre un signal de départ et un signal de fin de mesure.

Ce type de problème se pose dans tous les dispositifs où une mesure temporelle précise est nécessaire sur des durées très longues, en particulier dans les dispositifs utilisés dans le domaine de la télémétrie laser.

L'invention concerne également un dispositif qui permet de déterminer une distance à l'aide de la mesure du temps d'aller et retour d'une impulsion lumineuse entre un télémètre et une cible. L'impulsion lumineuse est émise par un laser : l'invention relève donc également du domaine de la télémétrie laser ou du LIDAR.

Elle trouve application dans la mesure de courte et moyenne distance, dans le domaine de l'automobile (pour la mise au point de systèmes anti-collision), dans le domaine de la dimensiométrie, dans celui de la perception de l'environnement pour la robotique.

Etat de la technique antérieure

Dans le domaine de la mesure de temps de grande précision, on fait appel :

- soit à des technique de moyennage qui augmentent considérablement le temps d'acquisition par rapport au temps mesuré. Ce type de technique ne peut pas être employé dans le cas où le temps d'acquisition doit être limité, et, par ailleurs, le moyennage n'est possible que si le phénomène mesuré présente une stationnarité convenable relativement au temps de moyennage.
- à des techniques de type "vernier", ces techniques reposant sur le comptage des périodes d'une horloge, pour une mesure grossière, et sur la détermination d'un complément temporel par une méthode analogique qui donne la précision à la mesure. Une telle technique est décrite dans l'article intitulé "The vernier time-measuring technique" de Robert G. Baron (proceedings of the IRE, janvier 1957), mais cette technique rallonge d'une quantité non négligeable le temps de mesure (5μs de temps de mesure pour une résolution de 20 ps avec des horloges de 100 mégahertz). Cette technique limite donc le nombre de mesures possibles bien en-deçà de la cadence de réalisation de certains événements,
- à des techniques de comptage haute fréquence qui seront limitées par la difficulté de mise en oeuvre et la fréquence maximum des compteurs.

La demande de brevet français FR-2 707 814 intitulée "Dispositif de mesure de la durée d'un intervalle de temps" décrit un procédé de mesure de temps qui permet d'enlever l'ambiguïté de comptage d'un coup d'horloge et tient compte des problèmes de non-synchronisme. Ce procédé n'est pas adapté à la mesure de durées temporelles importantes, supérieures à 10 μs, du fait de la décharge d'un condensateur du circuit qui peut entraîner une erreur importante sur de grands intervalles de mesure, notamment pour des applications de télémétrie à moyenne distance (supérieure à 1 km).

Le document US-5 200 933 décrit un dispositif qui permet la mesure précise d'un intervalle de temps, à l'aide d'une mesure grossière et d'une mesure fine. La mesure grossière est obtenue en comptant des impulsions d'horloge. La mesure fine est obtenue en digitalisant un signal triangulaire, synchrone de l'impulsion d'horloge. Les deux informations sont combinées dans un circuit de traitement pour calculer la durée de l'intervalle de temps entre une impulsion de départ et une impulsion de fin.

Ces deux dispositifs présentent des inconvénients majeurs rendant difficile la réalisation, que ce soit la conception de cartes électroniques ou celle de circuits intégrés.

Tout d'abord, on ne peut pas garantir des pentes identiques entre une rampe montante et une rampe descendante, c'est-à-dire que le temps de décharge du condensateur est différent du temps de charge. Ceci est dû essentiellement à l'utilisation d'un circuit de commutation différent (pour la charge et la décharge), tandis que le condensateur est commun. Par exemple, on utilise un transistor de type N pour la charge, et un transistor de type P pour la décharge.

De plus, le raccord entre la rampe montante et la rampe descendante n'est pas parfait pour des fréquences élevées. Ceci est dû à la commutation entre deux états.

Par ailleurs, la constance des pentes ne peut être garantie en fonction de la température ou des paramètres technologiques, dans le cas d'une intégration. Par exemple, la résistance $R_{ds}$on d'un transistor à effet de champ peut varier de 20% entre deux points extrêmes d'une plaquette de silicium.

Enfin, la linéarité des pentes ne peut pas être garantie sur toute la longueur pour des grandes dynamiques d'amplitude.

Le dispositif décrit dans le document US- 5 200 933 exige en outre, dans certains cas, de réaliser le calcul de la mesure fine des intervalles de temps de début et de fin avec des équations temporelles différentes.

Exposé de l'invention

La présente invention vise à proposer un dispositif permettant au moins la mesure des durées temporelles comprises entre 10 μs et l'infini.

Un problème à résoudre par l'invention est

**EP 0 793 153 B1**

d'éviter l'emploi de double rampe (une rampe montante et une descendante) afin d'éviter les inconvénients déjà exposés ci-dessus, liés à un tel emploi.

L'invention propose ainsi un dispositif de mesure de la durée d'un intervalle de temps compris entre un signal de début (D) et un signal de fin (F), caractérisé en ce qu'il comporte :

- une horloge (H) qui délivre des impulsions avec une période T,
- un circuit numérique pour compter le nombre d'impulsions de la première horloge qui sont suivies par une période entière T et qui sont comprises entre le signal de début (D) et le signal de fin (F),
- un circuit analogique pour déterminer d'une part le temps $t_1$ séparant le signal (D) et le début de la première impulsion de la première horloge qui commence après (D) et, d'autre part, le temps $t_2$ séparant le signal de fin (F) de la fin de la dernière période de la première horloge qui s'achève avant (F), et apte à convertir les données analogiques obtenues en données numériques,

ce circuit analogique comportant :

- des moyens pour engendrer N rampes de même direction, décalées entre elles d'une fraction de la période T,
- des moyens pour échantillonner au moins une des rampes aux instants où se produisent les signaux de début (D) et de fin (F) de l'intervalle à mesurer.

Ce dispositif ne met en oeuvre que des rampes de même direction, ce qui évite les problèmes de pentes différentes entre rampes montante et descendante. De même, sont évités les problèmes de raccordement entre rampes montante et descendante.

De plus, le calcul de la mesure fine des intervalles de temps de début et de fin met en oeuvre la même équation temporelle.

Selon un mode particulier de réalisation, le dispositif selon l'invention comporte des moyens pour engendrer des impulsions de période $\frac{T}{N}$, un premier et un second registres à décalage série-parallèle, ayant chacun d'une part une entrée série reliée à la sortie des moyens pour engendrer des impulsions de période $\frac{T}{N}$ et d'autre part des sorties parallèles en nombre N, chacun de ces registres pouvant délivrer, sur chacune de ses N sorties, des signaux ($I_1$, ..., $I_s$) de période T, décalés d'une durée $\frac{T}{N}$, par rapport aux signaux des sorties voisines, et chacune des N sorties étant reliée à un générateur de rampe.

Ce dispositif peut comporter des moyens pour échantillonner toutes les rampes aux instants de début (D) et de fin (F) de l'intervalle de temps à mesurer, et des moyens pour sélectionner la valeur échantillonnée qui se situe dans une portion prédéterminée d'une des rampes.

Ceci permet d'améliorer la linéarité du dispositif puisque seule une portion de la rampe est sélectionnée. De préférence, on sélectionne la portion située au centre de la rampe, ce qui est avantageux par rapport à une commutation en haut ou en bas de la rampe. Dans ce dernier cas, en effet, il peut se produire des instabilités, des pics de commutation, ou des problèmes du type "over-shoot" ou non-linéarité.

Des moyens peuvent être prévus pour déterminer la valeur de la pente des rampes. Dans ce cas, on s'affranchit des problèmes liés à une éventuelle variation des caractéristiques des composants constitutifs du dispositif, et la linéarité des pentes peut être garantie sur toute la longueur, pour des grandes dynamiques d'amplitudes.

Les moyens pour déterminer la pente des rampes peuvent notamment comporter des moyens pour engendrer une (N+1)$^{ième}$ rampe et des moyens pour échantillonner cette (N+1)$^{ième}$ rampe.

Selon un autre aspect, l'invention concerne également un dispositif de télémétrie laser, fonctionnant sur le principe de la mesure du temps de vol d'une impulsion lumineuse, caractérisé en ce qu'il comprend :

- un microlaser à déclenchement passif,
- des moyens de réception d'une impulsion lumineuse réfléchie par un objet et de détection de l'instant de réception de cette impulsion,
- des moyens de détection de l'instant d'émission d'une impulsion du microlaser,
- un dispositif, tel que décrit ci-dessus, pour mesurer l'intervalle de temps séparant l'instant d'émission de l'impulsion microlaser de l'instant de réception du faisceau réfléchi.

Un tel télémètre est particulièrement bien adapté aux mesures à moyennes distances (supérieures à 1 km, par exemple).

Le microlaser peut notamment comporter un milieu actif solide, un absorbant saturable, un miroir d'entrée, un miroir de sortie, l'absorbant saturable étant une couche mince de matériau absorbant saturable directement déposée sur le milieu actif solide.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1 illustre le principe de la mesure d'un intervalle de temps, selon la présente invention,
- la figure 2 est un schéma d'un dispositif pour la mise en oeuvre de l'invention,
- la figure 3 est un schéma d'un circuit diviseur de périodes,

- la figure 4 représente plus en détail une partie d'un dispositif pour la mise en oeuvre de l'invention,
- la figure 5 représente un générateur de rampes,
- la figure 6 représente un télémètre microlaser selon l'invention.

## Description détaillée de modes de réalisation de l'invention

Pour mesurer la durée d'un intervalle de temps déterminé, selon l'invention, on mesure la partie grossière de l'intervalle de temps de manière numérique, et la partie fine de manière analogique. Les paramètres ainsi acquis sont ensuite recombinés pour obtenir le résultat sur la durée à mesurer. La mesure de temps est ainsi obtenue en associant une grandeur numérique sous la forme d'un nombre de périodes d'horloge comptées, et des grandeurs analogiques obtenues par conversion de temps en amplitude de tension.

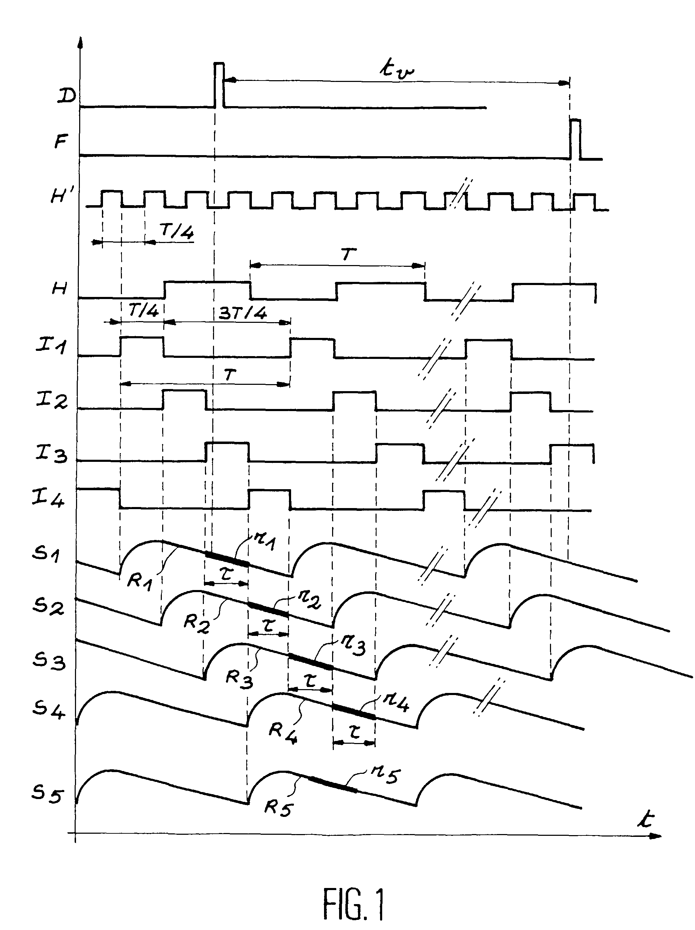

Ce principe est illustré plus précisément à l'aide du chronogramme de la figure 1. On cherche à mesurer l'intervalle de temps $t_v$ entre une impulsion de départ D et une impulsion de fin d'intervalle à mesurer F.

Pour cela, on utilise une horloge de base H, de période T. On compte le nombre n d'impulsions d'horloge qui sont suivies par une période entière T, et ceci pendant la durée $t_v$. Le temps total correspondant à l'écoulement de cette période est égal à nT. Comme l'horloge n'est pas synchrone avec les signaux de départ D et de fin F, il faut en outre déterminer d'une part le temps $t_1$, qui s'écoule entre le signal de départ D et le début de la première impulsion d'horloge qui commence après D, et, d'autre part, le temps $t_2$ qui s'écoule entre le signal de fin F et la fin de la dernière période d'horloge qui s'achève avant le signal F. Pour obtenir la durée de l'intervalle de temps $t_v$, il suffit ensuite d'additionner les trois temps mesurés : $t_1+nT+t_2$.

Pour déterminer $t_1$ et $t_2$, on utilise plusieurs signaux $S_1$-$S_4$ de période T, présentant au moins une zone linéaire $R_1$-$R_4$, chaque signal étant synchrone du signal d'horloge. Par exemple, comme illustré sur la figure 1, chaque signal $S_i$ (i=1-4) est en fait un signal permettant de définir une rampe descendante $R_i$, toutes les rampes ayant la même pente P. Quatre signaux ont été représentés sur la figure, mais il est possible de travailler avec des signaux en nombre N quelconque. Les signaux sont décalés l'un par rapport à l'autre d'une fraction $\frac{T}{N}$ ($\frac{T}{4}$ sur la figure 1). La durée des rampes linéaires $R_i$ ainsi que le décalage des signaux $S_i$ entre eux sont tels que, à chaque instant, on se trouve en coïncidence avec une portion linéaire $R_i$ d'un des signaux. Ainsi, tout signal de début D et/ou de fin F se trouve en coïncidence avec un point d'une portion linéaire $R_i$ d'un des signaux $S_i$. Sur la figure 1, le signal D se produit à un instant pour lequel il y a coïncidence avec un point de chacune des rampes $R_1$ et $R_2$.

A l'instant t, si $a_i$ est l'amplitude mesurée sur la rampe $R_i$, le temps écoulé depuis le début de la rampe est : $T-a_iP$.

Si l'impulsion de départ se produit au cours de la rampe $R_i$, on a alors : $t_1=T-a_iP$.

Si l'impulsion de fin F se produit au cours de la rampe $R_j$, on a : $t_2=T-a_jP$.

$t_1$ et $t_2$ sont ensuite numérisés, ce qui donne deux valeurs $T_1$ et $T_2$ correspondantes. On obtient ensuite la durée de l'intervalle de temps $t_v=n_T+T_1+T_2$.

A l'intérieur de chacune des rampes linéaires, l'utilisateur peut définir une portion de rampe à prendre en compte, ce qui permet d'améliorer la linéarité de la pente utilisée, et donc de la mesure : à cette fin, on choisit de préférence la portion de la rampe qui se trouve au centre de celle-ci, ce qui permet d'avoir un système stabilisé (c'est-à-dire sans problèmes de pics de commutation, d'"over-shoot" ou de non-linéarité) et de s'affranchir des distorsions aux extrémités de la rampe. Ainsi, dans le schéma de la figure 1, les portions sélectionnées $r_1$, $r_2$, $r_3$, $r_4$ ont une largeur temporelle $\tau$ et sont situées au centre de chacune des rampes $R_1$-$R_4$. Cette sélection correspond bien aux critères définis ci-dessus : à tout instant, et en particulier aux instants de début D et de fin F, il est possible de se trouver en coïncidence avec l'une ou l'autre des parties sélectionnées $r_i$ des différentes rampes $R_i$.

De préférence, lors de la présence du signal de début D ou de fin F, toutes les rampes sont échantillonnées, la valeur de l'amplitude de chaque rampe à cet instant est stockée, et on détermine ou on sélectionne ensuite la rampe à prendre en compte à cet instant. Notamment, si, à l'intérieur de chaque rampe, on a défini, comme sur la figure 1, une zone d'utilisation $r_i$, la rampe sélectionnée sera celle dont la zone d'utilisation se trouve en coïncidence avec le signal de début D ou de fin F se produisant.

Afin de pouvoir définir, de manière exacte, la pente P à prendre en compte, il est possible d'ajouter un signal $S_c$ de calibration, par exemple similaire à l'un des signaux de période T, et de mesurer la pente $P_0$ de la portion linéaire de ce signal de calibration ; cette portion linéaire peut être dénommée rampe de calibration $R_c$. Ainsi, sur la figure 1, un cinquième signal $S_5$, identique au quatrième $S_4$, permet de définir une rampe $R_5$ de calibration. De même que pour les autres rampes, il est possible de sélectionner, à l'intérieur de la rampe de calibration, une zone centrale $r_c$ (ou $r_5$), dite zone de calibration. La valeur de la pente de cette zone de la rampe est déterminée par échantillonnage de deux ou de plusieurs points caractéristiques de la rampe, et c'est cette valeur $P_o$ qui est ensuite utilisée pour réaliser les calculs de $t_1$, $t_2$ et $t_v$. Cette détermination de la rampe, simultanément à la mesure, permet d'éviter toute dérive, due par exemple à une modification des valeurs des composants mis en jeu, notamment dans le cas de la variation des conditions extérieures, par exemple des conditions de température. Cette mesure peut être réalisée pour toute détermination de la durée $t_v$ comprise

entre les signaux D et F ; de manière alternative elle peut n'être effectuée que lors la mise sous tension du dispositif.

En particulier, dans le cas où les dérives dues à la température sont prises en compte, la calibration sera effectuée lors de la première mise sous tension et ne sera plus nécessaire durant toute la vie du composant. Cette information issue de la calibration, est alors stockée dans une mémoire et est rappelée pour la correction des mesures.

Grâce à la calibration, la pente des rampes ou de leurs zones utiles peut être connue et déterminée avec une grande précision, ce qui permet d'améliorer la détermination et la dynamique de la mesure.

Grâce à ce procédé, l'équation temporelle à mettre en oeuvre est toujours la même, et rigoureusement identique d'une rampe à l'autre ($t_v = nT + t1 + t_2$).

L'utilisation de rampes de même direction et de même pente permet d'éviter les problèmes rencontrés lors de la mise en oeuvre de rampes alternativement montante et descendante (pentes non nécessairement identiques, raccord imparfait entre rampes montante et descendante).

Les différents signaux $S_1$-$S_4$ peuvent être déclenchés à l'aide d'impulsions $I_1$-$I_4$, elles-mêmes obtenues à partir d'impulsions d'horloge H' dont la période est une fraction ($\frac{T}{N}$) entière de la période T des impulsions d'horloge H. La précision sur les mesures peut être variée en faisant varier la fréquence des impulsions de l'horloge H'.

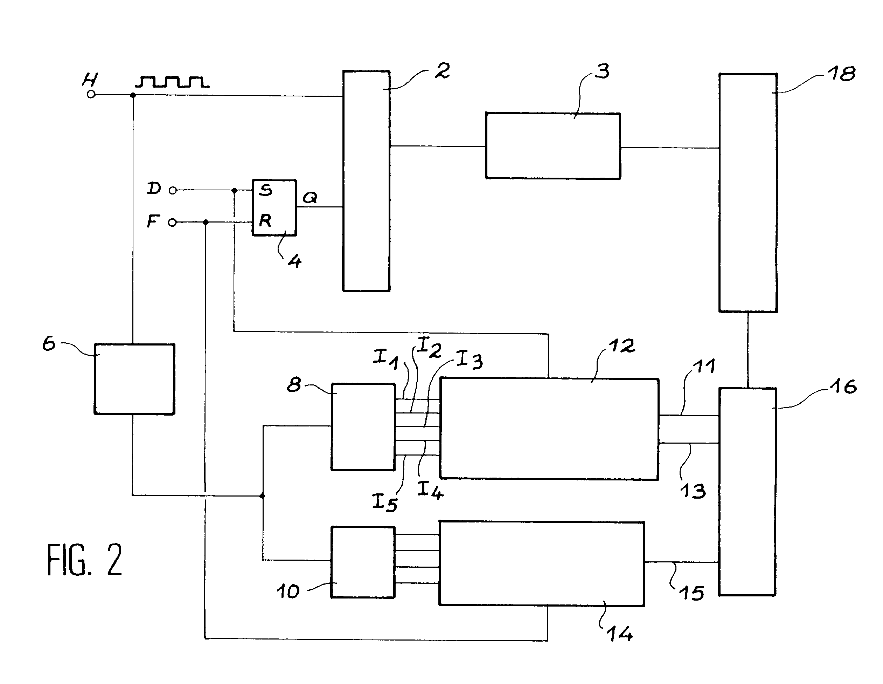

Un dispositif pour la mise en oeuvre de l'invention est représenté sur la figure 2. Une horloge H délivre des impulsions de période T sur une des entrées d'une porte ET désignée par la référence 2. Cette horloge H peut être réalisée à partir d'un oscillateur à quartz, fonctionnant par exemple à une fréquence de 50 MHz. L'autre entrée de la porte ET reçoit un signal à partir de la sortie Q d'une bascule RS désignée par la référence 4, sur l'entrée S de laquelle on envoie le signal de départ D, tandis que l'entrée R est pilotée par le signal de fin F. L'ensemble constitué par la porte ET, la bascule 4 et l'horloge H constitue un circuit de mesure numérique permettant d'obtenir une valeur grossière de l'intervalle de temps à mesurer. Cette valeur est égale à nT où n est le nombre de périodes d'horloge T écoulées entre le signal de début D et le signal de fin F. Elle est comptabilisée dans un compteur 3, puis transmise, sous la forme de données grossières sous huit bits, à un circuit de traitement 18.

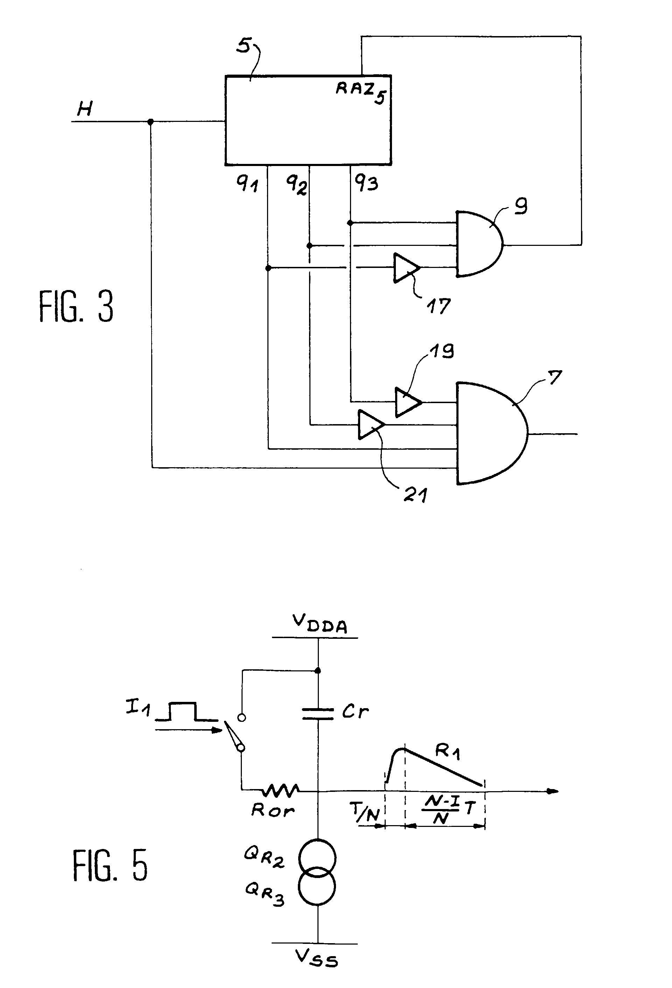

En parallèle, un circuit diviseur de période 6 permet de délivrer des impulsions d'horloge avec une période $\frac{T}{N}$. Un exemple de circuit diviseur est illustré sur la figure 3 pour N=6.

Les impulsions d'horloge sont envoyées sur un compteur synchrone 4 bits ou 3 bits désigné par la référence 5, ainsi que sur une porte ET 7. Deux sorties $q_2$, $q_3$ sont envoyées en entrée d'une porte ET 9, ainsi que le troisième signal de sortie $q_1$ inversé par un inverseur 17. Les deux sorties $q_2$, $q_3$ sont inversées par des inverseurs 19, 21 et envoyées en entrée de la porte 7, ainsi que le signal $q_1$.

La sortie de la porte 9 est bouclée sur la remise à zéro $RAZ_5$ du compteur 5. La sortie de la porte 7 délivre des impulsions d'horloge avec une période $\frac{T}{6}$

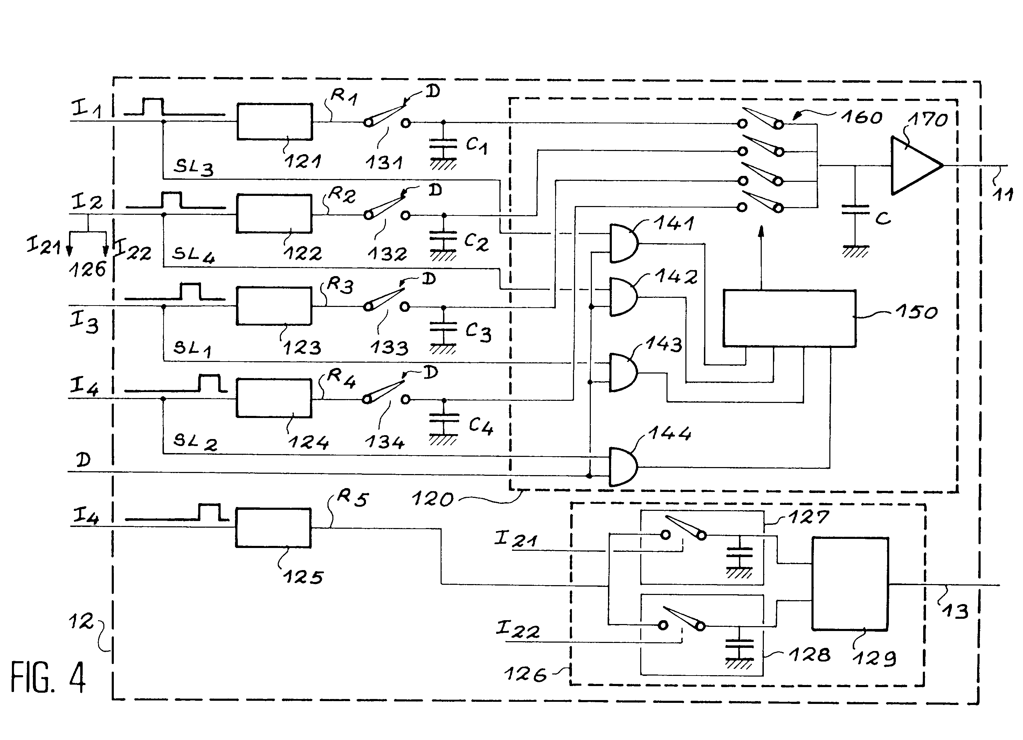

Pour une valeur N quelconque, il suffit de choisir un compteur synchrone avec un nombre de bits supérieur et de prendre la combinaison logique adaptée. Les impulsions de période $\frac{T}{N}$ ainsi obtenues alimentent les entrées de deux registres à décalage 8, 10 série-parallèle. En sortie du registre 8, on obtient N (ici : quatre) impulsions $I_1$-$I_4$ de largeur $\frac{T}{N}$, se répétant avec une période T (comme sur la figure 1). Une cinquième voie délivre des impulsions $I_5$ pour la calibration de la pente des rampes. Dans le cas de quatre rampes $I_1$-$I_4$, et pour une horloge H délivrant des impulsions à 50 MHz, on obtient donc, sur chaque voie i (i=1, 4) des signaux $I_i$ en forme de créneau, de période T (20 ns), et de durée $\frac{T}{N}$ ($=\frac{T}{4}$=5 ns). Les impulsions $I_1$-$I_5$ sont transmises à l'entrée d'un dispositif 12 qui va être décrit de manière plus précise à l'aide de la figure 4. Chacune des impulsions $I_1$-$I_5$ fait démarrer un générateur de rampes 121, 122, 123, 124, 125.

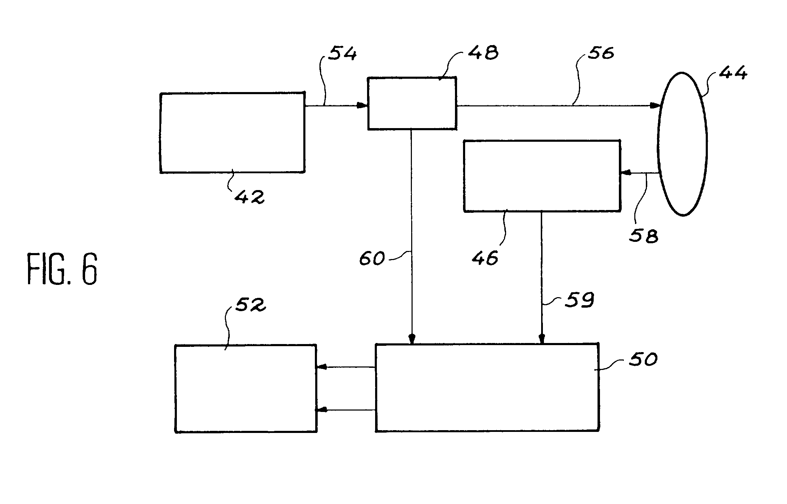

Un tel générateur comporte, comme illustré sur la figure 5, un condensateur $C_r$ ainsi qu'un générateur de courant réalisé par deux transistors $Q_{R2}$ et $Q_{R3}$. Lors de l'arrivée de l'impulsion $I_1$, le condensateur $C_r$ se charge pendant la durée $\frac{T}{N}$ (5 ns dans l'exemple ci-dessus). Pendant la durée

$$\left(\frac{N-1}{N}\right)T,$$

c'est la phase de décharge, la tension aux bornes du condensateur évoluant alors de manière linéaire, décroissante. On obtient ainsi une rampe décroissante, pendant la durée

$$\left(\frac{N-1}{N}\right)T.$$

Chacun des générateurs de rampe 121, 122, ..., 125 est constitué de la manière décrite sur la figure 5.

Les signaux de commande $I_1$-$I_4$ des quatre premières rampes étant décalés l'un par rapport à l'autre d'un quart de période (ou d'une durée $\frac{T}{N}$, dans le cas général), on obtient quatre rampes (ou N rampes), chacune étant décalée, par rapport aux rampes voisines, d'une durée de $\frac{T}{N}$. Du fait de ce décalage, les quatre rampes permettent de couvrir la période totale T. Lors de la présence du signal de départ D, les quatre rampes $R_1$-$R_4$ sont échantillonnées par des interrupteurs 131-134 et l'information est mémorisée, pour chaque rampe, par un condensateur $C_1$-$C_4$. Un circuit de sélection 120 permet ensuite de choisir la valeur échantillonnée de la rampe dans la portion utile qui coïncide avec le signal D. Le principe de la sélection consiste à effectuer une opération de combinaison ET logique entre le signal D (ou F) et chaque signal $I_1$, $I_2$, $I_3$, $I_4$. La portion utile de chaque rampe $R_i$ coïncide avec un de ces signaux, mais pas avec le signal $I_i$ de même indice. Ainsi, on voit sur la figure 1 que $r_1$ coïncide avec $I_3$, $r_2$ avec $I_4$, $r_3$ avec $I_1$ et $r_4$ avec $I_2$. Par conséquent, on peut définir, par exemple pour $r_1$, un signal de sélection $SL_1$ (=$I_3$) qui coïncide avec $r_1$. De même, pour $r_i$, on définit un signal de sélection $SL_i$ qui coïncide avec $r_i$. La combinaison ET mentionnée ci-dessus revient donc à faire une combinaison ET logique entre D (ou F) et chaque signal de sélection $SL_i$. Le résultat retenu est la valeur de la rampe $r_i$ dont le signal de sélection $SL_i$ donne 1 en combinaison logique ET avec le signal D (ou F).

Pour une valeur quelconque de N, le même principe est à utiliser : on définit, pour chaque rampe $R_i$ et sa portion linéaire utile correspondante, un signal de sélection $SL_i$, et on réalise la combinaison logique ET de $SL_i$ et de D (ou de F). Un circuit 120 pour réaliser cette sélection est illustré sur la figure 4. Chaque signal $I_i$ permet de former un signal de sélection $SL_j$ qui est combiné avec le signal D par une porte ET logique 141, 142, 143, 144. Un circuit 150 de commande d'interrupteur 160 permet de sélectionner l'information mémorisée dans le condensateur $C_i$ pour lequel le signal de sélection $SL_i$ coïncide avec le signal D (ou F). Un amplificateur 170 délivre sur une voie de sortie 11 le signal d'échantillonnage de la rampe sélectionnée.

La dernière voie de la figure 4 est la voie de calibration. Le signal $I_5$ fait démarrer un générateur de rampe 125 identique à celui décrit sur la figure 5. La rampe obtenue est échantillonnée par un dispositif 126, qui fonctionne sur le principe suivant. On identifie d'abord le signal $I_i$ avec lequel la zone centrale $r_5$ de calibration coïncide sensiblement. Ainsi, sur la figure 1, $r_5$ coïncide avec un créneau du signal $I_2$. Aux instants où se produisent les fronts montant et descendant de $I_2$ a lieu un échantillonnage, la durée séparant ces deux instants étant donnée par la durée $\tau_1 = \frac{T}{N}$ d'un créneau de $I_2$. Deux signaux $I_{21}$ et $I_{22}$ sont donc déclenchés par ces fronts montant et descendant (par exemple à l'aide d'une bascule D), ces signaux commandant chacun l'ouverture d'un circuit "Tracking and Hold" 127, 128 (voir figure 4). Un circuit 129 peut ensuite calculer la valeur de la pente $\tau_1/V_1$-$V_2$). La valeur numérisée est délivrée en sortie 13.

Sur la voie correspondant à l'impulsion F de fin, le dispositif 10 est similaire au dispositif 8. Si une voie de calibration est prévue dans les moyens 8 et 12, le dispositif 10 n'a pas besoin d'incorporer une telle voie. De manière réciproque, la voie de calibration peut être prévue dans le dispositif 10. De même, les moyens 14 sont similaires aux moyens 12, l'échantillonnage des rampes étant réalisé au moment de l'arrivée de l'impulsion de fin F.

Les valeurs correspondant respectivement aux amplitudes des rampes, retenues aux instants de début D et de fin F de l'intervalle de temps à mesurer, et les valeurs échantillonnées sur la voie de calibration, sont ensuite transmises par les voies 11, 15, 13 à un dispositif de mémorisation 16, puis à un circuit de traitement 18 qui calcule la durée $t_v$ de l'intervalle de temps à mesurer.

Le dispositif décrit ci-dessus peut être incorporé dans un télémètre, comme décrit sur la figure 6. Un microlaser à déclenchement passif 42 envoie un faisceau lumineux 54 en direction d'un objet 44 dont on veut déterminer la position. Un faisceau 58 réfléchi par cet objet 44 est dirigé vers des moyens optiques 46 de réception d'un faisceau lumineux, comme par exemple un séparateur de faisceaux combiné à une lentille de réception. Le faisceau 59 obtenu en sortie des moyens 46 de réception du faisceau réfléchi 58 est dirigé vers un circuit de détection 50 comportant par exemple un composant photodétecteur qui va fournir une impulsion électrique marquant la fin de l'intervalle que l'on doit mesurer pour déterminer le temps de vol du faisceau. Ce circuit comprend en outre une chaîne amplificatrice (composée d'amplificateurs), qui fournit à un étage comparateur un signal de fin de l'intervalle à mesurer. Ce signal est transmis au dispositif 52 de mesure de temps, qui est en fait un dispositif de mesure d'un intervalle de temps tel qu'il a été décrit ci-dessus. Par ailleurs, le télémètre comporte également des moyens de détection de l'instant d'émission d'une impulsion du microlaser. Ces moyens peuvent comporter par exemple un dispositif 48 de prélèvement d'une partie 60 du flux lumineux du faisceau 54 émis par le microlaser 42, par exemple une lame séparatrice.

Le microlaser 42 est de préférence un microlaser à déclenchement passif, dont la cavité comporte un milieu actif solide, un absorbant saturable, un miroir d'entrée et un miroir de sortie, l'absorbant saturable étant une couche mince de matériau absorbant saturable directement déposée sur le milieu actif solide. Un tel microlaser et son procédé de réalisation sont décrits dans le document EP-0 653 824. Par conséquent, dans le cadre de la présente invention, et conformément à l'enseignement de ce document antérieur, la couche mince d'absorbant saturable pourra être composée :

-   ou bien d'un colorant organique en solution dans un solvant polymère (le colorant organique pouvant être choisi parmi le bis(4-diéthyulaminodithioboenzyl) nickel ou le bis(4-diméthylaminodithiobenzyl) nickel, le solvant étant une solution de poly(méthyméthacrylate) (PMMA), de poly(vinylalcool) ou de poly(vinyl acétate) ou de poly(styrène)).
-   ou bien une couche mince susceptible d'avoir été déposée par épitaxie en phase liquide ; ce peut être une couche mince composée d'un matériau de base, identique à celui du milieu actif solide, et dopé avec des ions $Cr^{4+}$ ou $Er^{3+}$.

Dans le premier cas (colorant organique et solvant polymère) on peut former la couche mince en le déposant directement sur une des faces du matériau constitutif du milieu actif solide, selon la technique de la tournette. Tous les autres détails concernant la réalisation de cet absorbant saturable sous forme de couche mince, et la réalisation d'un microlaser, sont donnés dans le document EP-0 653 824.

Le fait de déposer l'absorbant saturable sous la forme d'une couche mince, directement sur le matériau actif du microlaser présente plusieurs avantages :

- le microlaser déclenché est réalisé sous la forme d'un empilement de couches, ce qui permet de garder la possibilité d'une fabrication collective à coût faible, et ce qui ne remet pas en cause la simplicité et les procédés de fabrication collective des microlasers, tels qu'ils ont été développés pour les microlaser continus,
- le microlaser déclenché ainsi obtenu est monolithique, autoaligné (il ne nécessite aucun réglage optique) et indéréglable ; par conséquent cette structure ne nécessite aucune opération de collage ni aucune opération complexe d'alignement de la cavité microlaser. Enfin, par rapport aux lasers "codopés", le milieu actif est séparé de l'absorbant saturable, et on peut régler indépendamment les épaisseurs et les concentrations des ions dans les deux milieux ; par ailleurs, grâce à cette séparation, on peut réaliser des lasers déclenchés où le même ion peut être utilisé comme ion actif et comme absorbant saturable, avec des concentrations différentes.

Dans le cas du télémètre laser ci-dessus, l'instant de départ de la mesure de temps est donné par l'impulsion lumineuse issue du microlaser. La période de réception de l'impulsion lumineuse est liée au déclenchement du microlaser, qui est asynchrone par rapport à l'horloge du chronomètre. L'instant de fin de mesure est lié au retour de cette même impulsion, qui a parcouru une distance double du trajet entre le microlaser 42 et la cible 44. Le signal issu de la détection est, lui aussi, asynchrone par rapport à l'horloge du chronomètre. Les applications qui sont envisagées pour ce type de télémètre nécessitent un dispositif de chronométrie précis, avec la discrimination de durée temporelle de quelques picosecondes, pour des mesures de quelques microsecondes.

Le dispositif de mesure d'un intervalle de temps tel qu'il a été décrit ci-dessus est particulièrement bien adapté pour l'application à la télémétrie microlaser, car il offre une précision constante quelle que soit la durée de l'intervalle de temps. En outre, ce dispositif ne demande pas d'initialisation préalable pour permettre une mesure, car les rampes sont récurrentes et évitent les conditions initiales dans les circuits.

Le télémètre microlaser décrit ci-dessus peut être utilisé dans l'industrie automobile, pour réaliser des dispositifs anti-collision ou des dispositifs des détections d'obstacles.

## Revendications

1. Dispositif de mesure de la durée d'un intervalle de temps compris entre un signal de début (D) et un signal de fin (F), caractérisé en ce qu'il comporte :

   - une horloge (H) qui délivre des impulsions avec une période T,
   - un circuit numérique (2, 3, 4) pour compter le nombre d'impulsions de la première horloge qui sont suivies par une période entière T et qui sont comprises entre le signal de début (D) et le signal de fin (F),
   - un circuit analogique (6, 8, 10, 12, 14) pour déterminer d'une part le temps $t_1$ séparant le signal (D) et le début de la première impulsion de la première horloge qui commence après (D), et d'autre part le temps $t_2$ séparant le signal de fin (F) de la fin de la dernière période de la première horloge qui s'achève avant (F), et apte à convertir les données analogiques obtenues en données numériques,

   ce circuit analogique comportant :

   - des moyens (8, 10, 121, 122, 123, 124, 125) pour engendrer N rampes ($R_1$-$R_4$) de même direction, décalées entre elles d'une fraction de la période T,
   - des moyens ($C_1$-$C_4$, 120) pour échantillonner au moins une des rampes aux instants où se produisent les signaux de début (D) et de fin (F) de l'intervalle à mesurer.

2. Dispositif selon la revendication 1, comportant des moyens (6) pour engendrer des impulsions de période $\frac{T}{N}$, un premier (8) et un second (10) registres à décalage série-parallèle, ayant chacun d'une part une entrée série reliée à la sortie des moyens (6) pour engendrer des impulsions de période $\frac{T}{N}$ et d'autre part des sorties parallèles en nombre N, chacun de ces registres pouvant délivrer, sur chacune de ses N sorties, des signaux ($I_1$, ..., $I_5$) de période T, décalés d'une durée $\frac{T}{N}$ par rapport aux signaux des sorties voisines, et chacune des N sorties étant reliée à un générateur de rampe (121, 122, ... 124).

3. Dispositif selon l'une des revendications 1 ou 2, comportant des moyens (131-134, $C_1$-$C_4$) pour échantillonner toutes les rampes aux instants de début (D) et de fin (F) de l'intervalle de temps à mesurer, et des moyens (120) pour sélectionner la valeur échantillonnée qui se situe dans une portion prédéterminée d'une des rampes.

**4.** Dispositif selon la revendication 3, les moyens (120) pour sélectionner la valeur échantillonnée se situant dans une portion prédéterminée d'une des rampes comportant des moyens pour déterminer la coïncidence d'un signal de sélection (SL$_i$) de chaque rampe avec les instants de début (D) et de fin (F).

**5.** Dispositif selon l'une des revendications précédentes, comportant en outre des moyens (125, 126) pour déterminer la valeur de la pente des rampes.

**6.** Dispositif selon la revendication 5, les moyens pour déterminer la pente des rampes comportant des moyens (125) pour engendrer une (N+1)$^{ième}$ rampe (R$_5$) et des moyens (126) pour échantillonner cette (N+1)$^{ième}$ rampe.

**7.** Dispositif de télémétrie laser, fonctionnant sur le principe de la mesure du temps de vol d'une impulsion lumineuse, caractérisé en ce qu'il comprend :

- un microlaser (42) à déclenchement passif,
- des moyens (48, 50) de réception d'une impulsion lumineuse (58, 59) réfléchie par un objet (44) et de détection de l'instant de réception de cette impulsion,
- des moyens (48, 50) de détection de l'instant d'émission d'une impulsion du microlaser (2),
- un dispositif (50, 52) selon l'une des revendications 1 à 6 pour mesurer l'intervalle de temps séparant l'instant d'émission d'une impulsion microlaser de l'instant de réception d'un faisceau réfléchi.

**8.** Dispositif selon la revendication 7, le microlaser (42) comportant un milieu actif solide, un absorbant saturable, un miroir d'entrée, un miroir de sortie, l'absorbant saturable étant une couche mince de matériau absorbant saturable directement déposée sur le milieu actif solide.

**Patentansprüche**

**1.** Messvorrichtung eines zwischen einem Anfangssignal (D) und einem Endsignal (F) enthaltenen Zeitintervalls,
   **dadurch gekennzeichnet,** dass sie umfasst:

- einen Takt (H), der Impulse mit einer Periode T liefert,
- eine Digitalschaltung (2, 3, 4) zum Zählen der Anzahl der Impulse des ersten Takts, auf die eine ganze Periode T folgt und die zwischen dem Anfangssignal (D) und dem Endsignal (F) enthalten sind,
- eine Analogschaltung (6, 8, 10, 12, 14), um einerseits einen Teil der Zeit t$_1$ zu bestimmen, die das Signal (D) und den Anfang des ersten Impulses des ersten Takts trennt, der nach (D) beginnt und andererseits die Zeit t$_2$ zu bestimmen, die das Endsignal (F) von dem Ende der letzten Periode des ersten Takts trennt, der vor (F) endet, und fähig, die erhaltenen analogen Größen in digitale Größen bzw. Daten umzusetzen,

   wobei diese Analogschaltung umfasst:

- Einrichtungen (8, 10, 121, 122, 123, 124, 125) um N Sägezahnspannungen (R$_1$-R$_4$) derselben Richtung zu erzeugen, zueinander versetzt um einen Bruchteil der Periode T,
- Einrichtungen (C$_1$-C$_4$, 120) um wenigstens eine der Sägezahnspannungen zu den Zeitpunkten abzutasten, wo sich die Anfangssignale (D) und Endsignale (F) des zu messenden Intervalls ereignen.

**2.** Vorrichtung nach Anspruch 1 mit Einrichtungen (6) zum Erzeugen der Impulse der Periode T/N und einem ersten (8) und zweiten (10) seriell-parallelen Schieberegister, jedes mit einerseits einem mit dem Ausgang der Einrichtungen (6) verbundenen seriellen Eingang, um Impulse der Periode T/N zu erzeugen, und andererseits N parallelen Ausgängen, wobei jedes dieser Register an jedem seiner N Ausgänge Signale (I$_1$, ..., I$_5$) der Periode T liefert, versetzt um eine Dauer T/N in Bezug auf die Signale der benachbarten Ausgänge, und jeder der N Ausgänge mit einem Sägezahngenerator (121, 122, .. 124) verbunden ist.

**3.** Vorrichtung nach einem der Ansprüche 1 oder 2 mit Einrichtungen (131-134, C$_1$-C$_4$) zum Abtasten aller Sägezahnspannungen zu den Zeitpunkten des Anfangs (D) und des Endes (F) des zu messenden Zeitintervalls, und Einrichtungen (120) zum Selektieren des abgetasteten Werts, der sich in einem vorher festgelegten Teil einer der Sägezahnspannungen befindet.

**4.** Vorrichtung nach Anspruch 3, wobei die Einrichtungen (120) zum Selektieren des abgetasteten Werts sich in einem vorher festgelegten Teil einer der Sägezahnspannungen befindet, mit Einrichtungen, um die Übereinstimmung eines Selektionssignals (SL$_i$) jedes Sägezahns mit den Anfangs- und Endzeitpunkten (D) und (F) zu bestimmen.

**5.** Vorrichtung nach einem der vorhergehenden Ansprüche mit außerdem Einrichtungen (125, 126), um den Wert der Neigung der Sägezahnspannungen zu bestimmen.

**6.** Vorrichtung nach Anspruch 5, wobei die Einrichtungen zum Bestimmen der Neigung der Sägezahnspannungen Einrichtungen (125) zum Erzeugen einer (N+1)-ten Sägezahnspannung ($R_5$) und Einrichtungen (126) zum Abtasten dieser (N+1)-ten Sägezahnspannung umfassen.

**7.** Lasertelemetrievorrichtung, die nach dem Prinzip des Messens der Flugzeit eines Lichtimpulses arbeitet,
**dadurch gekennzeichnet,** dass sie umfasst:

- einen Mikrolaser (42) mit passiver Güteschaltung,
- Einrichtungen (48, 50) um einen durch ein Objekt (44) reflektierten Lichtimpuls (58, 59) zu empfangen und den Zeitpunkt des Empfangs dieses Impulses festzustellen,
- Einrichtungen (48, 50) zum Feststellen des Sendezeitpunkts eines Impulses des Mikrolasers (2),
- eine Vorrichtung (50, 52) nach einem der Ansprüche 1 bis 6 zum Messen des Zeitintervalls, das den Sendezeitpunkt eines Mikrolaserimpulses vom Empfangszeitpunkt eines reflektierten Strahls trennt.

**8.** Vorrichtung nach Anspruch 7, wobei der Mikrolaser (42) ein aktives Festkörpermedium, ein sättigbares Absorptionsmaterial, einen Eingangsspiegel und einen Ausgangsspiegel umfasst und das sättigbare Absorptionsmaterial eine direkt auf dem aktiven Festkörpermedium abgeschiedene Dünnschicht ist.

**Claims**

**1.** Device for measuring the duration of a time interval between a start signal (D) and an end signal (F) comprising:

- a clock (H) which supplies pulses with a period (T),
- a digital circuit (2, 3, 4) to count the number of pulses from the first clock which are followed by a whole period T and which are included between the start signal (D) and the end signal (F),
- an analog circuit (6, 8, 10, 12, 14) to determine, on the one hand, the time $t_1$ separating signal (D) and the start of the first pulse of the first clock which begins after (D), and, on the other hand, the time $t_2$ separating the end signal (F) from the end of the last period of the first clock which ends before (F), and is capable of converting the analog data obtained into digital data,

- this analog circuit comprising:

  means (8, 10, 121, 122, 123, 124, 125) of generating N ramps ($R_1$-$R_4$) with the same direction, displaced from one another by a fraction of the period T,
  means ($C_1$-$C_4$, 120) for sampling at least one of said ramps at the instants that the start (D) and end (F) signals of the interval to be measured occur.

**2.** Device according to claim 1, comprising means (6) for generating pulses of period T/N, first (8) and second (10) registers with series-parallel shift, each having, on the one hand a series input connected to the output of the means (6) for generating pulses of period T/N and, on the other hand parallel outputs, N in number, each of these registers being able to supply, on each of its N outputs, signals ($I_1$, ..., $I_5$) of period T, displaced by a period of time T/N with respect to the signals from the neighbouring outputs, and each of the N outputs being connected to a ramp generator (121, 122, ..., 124).

**3.** Device according to one of claims 1 or 2, comprising means (131-134, $C_1$-$C_4$) for carrying out a sampling of all the ramps at the instants of the start (D) and the end (F) of the interval of time to be measured, and means (120) for selecting the sampled value which is located in a predetermined portion of one of the ramps.

**4.** Device according to claim 3, the means (120) for selecting the sampled value being located in a predetermined portion of one of the ramps comprising means for determining the coincidence of a selection signal ($SL_i$) from each ramp with the start (D) and end (F) instants.

**5.** Device according to any one of the preceding claims, comprising means (125, 126) for determining the value of the slope of the ramps.

**6.** Device according to claim 5, the means for determining the slope of the ramps comprising means (125) for generating a (N+1)th ramp ($R_5$) and means (126) for sampling this (N+1)th ramp.

**7.** Laser telemetry device, operating on the principle of measuring the flight time of a light pulse, characterized in that it includes:

- a passively triggered microlaser (42),
- means (48, 50) of receiving a light pulse (58, 59) reflected by an object (44) and of detecting the instant of reception of this pulse,
- means (48, 50) of detecting the instant of emission of a pulse from microlaser (2),

- a device (50, 52) according to any one of the claims 1 to 6 for measuring the time interval separating the instant of emission of a microlaser pulse and the instant of reception of a reflected beam.

8. Device according to claim 7, the microlaser (42) comprising a solid active medium, a saturable absorber, an input mirror, an output mirror, the saturable absorber being a thin layer of saturable absorbent material deposited directly onto the solid active medium.

FIG. 1

FIG. 2

EP 0 793 153 B1

FIG. 3

FIG. 5

FIG. 4

EP 0 793 153 B1

FIG. 6

EP 0 793 153 B1